# EUROPEAN PATENT SPECIFICATION

(11) **EP 3 264 479 B1**
(45) Date of publication and mention of the grant of the patent: **01.01.2020**
(21) Application number: 17178536.3
(22) Date of filing: 28.06.2017
(51) Int. Cl.: H01L 35/30, F28F 9/26

(54) **THERMOELECTRIC HEAT RECOVERY**
THERMOELEKTRISCHE WÄRMERÜCKGEWINNUNG
RÉCUPÉRATION DE CHALEUR THERMOÉLECTRIQUE

(30) Priority: 30.06.2016 EP 16177352
(43) Date of publication of application: 03.01.2018
(73) Proprietor: European Thermodynamics Limited, Kibworth, Leicester LE8 0RX (GB)
(72) Inventor: FRANCESCONI, Guido, Leicester, Leicestershire LE8 0RX (GB); CHIWANGA, States, Cambridge, Cambridgeshire CB3 0GT (GB); TULEY, Richard, Leicester, Leicestershire LE8 0RX (GB)
(74) Representative: Barker Brettell LLP

(56) References cited:
- EP-A2- 2 573 831
- EP-A2- 2 874 191

## Description

The present invention relates to thermoelectric heat recovery systems. In particular, the invention provides an improved thermoelectric heat recovery system for converting waste heat into electricity.

In recent years, there has been a global drive to develop environmentally friendly solutions which reduce waste energy. As such, there is an on-going demand for a more efficient thermoelectric heat recovery system.

A thermoelectric generator is an energy generating device which can be used wherever there is a temperature difference. For example, a thermoelectric generator can operate using the temperature difference between a hot pipe or surface and the ambient air temperature. A thermoelectric generator comprises one or more elements comprising one or more thermoelectric materials which are semiconductors having low thermal conductivity but high electrical conductivity and a high Seebeck coefficient. When a temperature gradient is established across an element comprising a thermoelectric material, electrons or holes flow across the material, thereby generating an electrical current.

Thermoelectric generators may be used to convert waste heat emitted from vehicle exhaust systems and industrial flues or furnaces into electricity. Typically, a thermoelectric heat recovery system comprises multiple thermoelectric generators. The electrical energy generated by such a system may be stored (e.g. in a battery) or it may be used to at least partially power one or more devices. For example, in an exhaust heat recovery system, the electrical energy output may be used to at least partially power a motor (e.g. in a hybrid vehicle), charge one or more batteries, or supply power to one or more electrical components in the vehicle.

It is known for a thermoelectric heat recovery system to comprise a bypass circuit. The bypass circuit may provide an alternative path for the fluid from which the waste heat is extracted (e.g. heat exchange fluid, such as steam) that is not in thermal communication with the thermoelectric generator(s). Generally, the bypass circuit is activated when the temperature of the fluid and/or of one or more thermoelectric generators exceeds a critical threshold. An example of a known bypass control circuit is disclosed in US8554407.

The efficiency of most known thermoelectric heat recovery systems is at least partially limited by the existence of a gradient in the temperature of the hot side of the thermoelectric generator(s) in the direction of flow of the heat exchange fluid. This gradient is caused by heat loss from the fluid as it travels through the heat recovery system. Consequently, there will be a smaller temperature difference between the hot side and the cold side of a given thermoelectric generator located at or near a downstream (cooler) end of the heat recovery system than between the hot side and the cold side of a given thermoelectric generator located at or near an upstream (hotter) end of the heat recovery system.

The thermoelectric generators will have a maximum temperature limit, determined principally by the thermoelectric material and compatible assembly method. A problem can arise, since the gradient in the temperature of the hot side of the thermoelectric generator(s) may reduce the maximum average hot side temperature of the thermoelectric generator(s), because the maximum average hot side temperature of the system is reached when the maximum hot side temperature of at least some of the thermoelectric generator(s) is reached.

A large temperature difference between the hot and cold side of the thermoelectric generator(s) is desired for a high efficiency and a high electrical power output. Therefore, if the maximum average hot side temperature of the thermoelectric generator(s) in the system is reduced, there may be a reduced average temperature difference between the hot and cold side of the thermoelectric generator(s) with the effect that the efficiency and electrical output of the thermoelectric generator(s) may be reduced. It may therefore be desirable to reduce the gradient in the hot side of the thermoelectric generator(s).

A gradient in the temperature of the hot side of the thermoelectric generator(s) can, in addition, lead to a gradient in the temperature difference between the hot and cold side of the thermoelectric generator(s).

A gradient in the temperature of the hot side or the cold side of the thermoelectric generator(s) can cause thermal expansion problems and reduce the output of the thermoelectric generator(s).

It may therefore be desirable to reduce the gradient in the temperature difference between the hot and cold side of the thermoelectric generator(s), as this could reduce electrical mismatch between the outputs of the thermoelectric generator(s) and/or could reduce thermal expansion problems.

One known solution to the problem of the temperature gradient on the hot side of the thermoelectric generator(s) is to use different thermoelectric materials in thermoelectric generators with different maximum temperature limits at different positions along the heat recovery system. For example, the heat recovery system may be divided into high, medium and low temperature zones with thermoelectric generators comprising different thermoelectric materials for each zone. An example of such a thermoelectric heat recovery system is disclosed in US20110067742. It is also known to regulate flow rate throughout the thermoelectric heat recovery system to control the amount of heat loss from the fluid.

Another known solution is to attempt to reduce the temperature gradient on the hot side of the thermoelectric generator(s) by optimising the distribution of heat exchange fins in the pipe(s) or conduit(s) through which the heat exchange fluid flows. The density of the fin distribution can be increased towards the outlet of the conduit to increase the proportion of heat transferred from the fluid to the hot side of the thermoelectric generator, thereby at least partially compensating for the lower average temperature of the fluid towards the outlet. An example of such a system is disclosed in US20130340801.

To reduce the gradient in the temperature difference between the hot and cold sides of the thermoelectric generator(s), but not the gradient in the hot side temperature, it is known that for heat pumping applications air flow in opposite directions on the hot and cold side of a thermoelectric module can be used, as described in US 4065936A1.

To reduce the gradient in temperature across a heat exchanger, a serpentine or dual or multiple pass flow pattern can be used, and this is known in the prior art, for example in the International Journal of Thermal Sciences 102 (2016) 137-144.

EP 2 874 191 describes a thermoelectric heat recovery system whereby electric current is generated from a temperature gradient. The system has two circuits in which a cold and a hot fluid flow.

EP 2 573 831 describes a general arrangement whereby a cold an hot air stream are guided along thermoelectric elements which are sandwiched between the hot and cold air fluid conduits.

According to a first aspect of the invention, there is provided a thermoelectric heat recovery system comprising: an inlet for receiving a fluid; an outlet; a heat exchanger located between, and in fluid communication with, the inlet and the outlet, the heat exchanger comprising a plurality of heat exchange conduits, wherein, in use, the fluid flows in a first direction through a given heat exchange conduit and in a second direction opposite to the first direction through the or each heat exchange conduit adjacent the given heat exchange conduit; and one or more thermoelectric generators, wherein the or each thermoelectric generator has a heat exchanger contact surface which is in thermal contact with at least a portion of at least two adjacent heat exchange conduits, such that, in use, the heat exchanger contact surface forms the hot side or cold side of the thermoelectric generator.

In some embodiments, the thermoelectric heat recovery system may comprise a plurality of thermoelectric generators. Optionally, the thermoelectric generator(s) may be in thermal contact with all of the heat exchange conduits along substantially the entire length of the heat exchange conduits.

This heat exchanger design presents a high cross-sectional area substantially perpendicular to the main fluid flow direction, due to the number of conduits acting in parallel.

If the fluid flowing through the heat exchange conduits is a hot fluid relative to the surrounding ambient air (or other fluid) then the heat exchanger contact surface(s) in thermal contact with at least a portion of at least two adjacent heat exchange conduits forms, in use, the hot side of the thermoelectric generator(s).

Conversely, if the fluid flowing through the heat exchange conduits is a cold fluid relative to the surrounding ambient air (or other fluid) then the heat exchanger contact surface(s) in thermal contact with at least a portion of at least two adjacent heat exchange conduits forms, in use, the cold side of the thermoelectric generator(s).

The heat recovery system of the present invention reduces the difference in the temperature of the heat exchanger contact surfaces of the thermoelectric generators. In other words, the present invention reduces the difference between the temperature of the hot side (or alternatively cold side) between each of the thermoelectric generators.

For a heat recovery system using a hot fluid the temperature of the fluid will decrease due to thermal losses as the fluid flows along each heat exchange conduit from the inlet towards the outlet. The reverse is true for a heat recovery system using a cold fluid. Thus, as each thermoelectric generator has a heat exchanger contact surface which is in thermal contact with at least a portion of at least two adjacent heat exchange conduits, and as the fluid flows in opposite directions in adjacent conduits, these thermal losses (or gains) are averaged out. This results in each heat exchanger contact surface having substantially the same average temperature (or surface temperature). Hence, in use, the hot side (or cold side) of each thermoelectric generator may be at a similar or even substantially the same temperature.

Advantageously, reducing the gradient in the temperature of the hot side (or cold side) of the thermoelectric generators may also reduce any differential thermal expansion of the heat exchanger.

In some embodiments, the gradient in the temperature of the hot side (or cold side) of the thermoelectric generators may be minimised and/or the gradient may be substantially neutralised.

The present invention may be advantageous compared with heat recovery systems which optimise the distribution of heat exchange fins in the heat exchange conduit, e.g. US20130340801. For example, in US20130340801 the heat exchange fin distribution is optimised for a certain flow rate and temperature of the fluid. In practice, the flow rate and temperature of the fluid through the heat exchanger is not constant, thus the gradient in the temperature of the hot side of the thermoelectric generators would not be cancelled unless the flow rate and temperature of the fluid were strictly controlled. This is not required in the present invention, as a change in the flow rate or inlet temperature of the fluid will affect all of the thermoelectric generators equally.

In addition, heat exchangers used with a hot fluid typically have a low thermal resistance (i.e. high rate of heat transfer to the hot side of the thermoelectric generators), even without the use of fins. It can therefore be very difficult for heat exchange fins to effectively adjust the amount of heat transferred from the fluid to the thermoelectric generators. The use of heat exchange fins, particularly if they are very densely packed, can also increase thermal stresses in the heat exchanger and the pressure drop.

Optionally, the length of each heat exchange conduit may be substantially the same.

In some embodiments, some or all of the plurality of heat exchange conduits may be substantially parallel to each other along at least a portion of their lengths. Additionally or alternatively, at least two adjacent heat exchange conduits may be wound helically around each other along at least a portion of their lengths.

Optionally, each pair of adjacent heat exchange conduits may comprise at least one common wall. The at least one common wall may have a high thermal conductivity and/or low thermal resistance.

In some embodiments, each heat exchange conduit in a given heat exchanger may comprise a first end and a second end, wherein, in use, fluid may flow from the first end of a heat exchange conduit to the second end of the heat exchange conduit. The heat exchange conduits in a given heat exchanger may be arranged such that the first end of a given heat exchange conduit is adjacent to the second end of the or each adjacent heat exchange conduit.

The first end of each heat exchange conduit may be in fluid communication with the inlet. The second end of each heat exchange conduit may be in fluid communication with the outlet.

Optionally, the heat exchanger may comprise a plurality of first heat exchange conduits and a plurality of second heat exchange conduits, the direction of fluid flow, in use, through the first heat exchange conduits being opposite that through the second heat exchange conduits. Each first heat exchange conduit may be positioned adjacent to at least one second heat exchange conduit. The first end of each first heat exchange conduit may be adjacent to the second end of a second heat exchange conduit.

In some embodiments, at least one given first heat exchange conduit may be in fluid communication with one of the second heat exchange conduits such that the second heat exchange conduit is located downstream of the given first heat exchange conduit . Each first heat exchange conduit may be in fluid communication with a second heat exchange conduit, such that the first and second heat exchange conduits are connected in pairs. The first end of each first heat exchange conduit may be in fluid communication with the inlet. Additionally or alternatively, the second end of each second heat exchange conduit may be in fluid communication with the outlet. For example, in use, fluid may flow from the inlet through a given first heat exchange conduit, then through a given second heat exchange conduit, then to the outlet.

Each first heat exchange conduit may be in fluid communication with an adjacent second heat exchange conduit. For example, in use, fluid may flow through a first heat exchange conduit in a first direction then through the adjacent second heat exchange conduit in a second direction.

In some embodiments, the heat recovery system may comprise two or more heat exchangers, typically arranged in series. Optionally, the heat exchangers may be arranged in layers (e.g. stacked one disposed at least partially above another or one surrounding another). In other embodiments, at least two of the heat exchangers may be disposed adjacent to each other.

Advantageously, the arrangement of the heat exchangers may improve, or maximise, the power output of the heat recovery system for the amount of space available.

The heat exchangers may be at least partially in thermal contact with each other.

Some or all of the two or more heat exchangers may be in fluid communication with one another.

For example, the heat recovery system may comprise an upper heat exchanger and a lower heat exchanger. The upper and lower heat exchangers may each comprise a plurality of first heat exchange conduits and a plurality of second heat exchange conduits. Each first heat exchange conduit may be adjacent to at least one second heat exchange conduit. In use, fluid may flow in an opposite direction in the first heat exchange conduits compared with the second heat exchange conduits.

For example, each first heat exchange conduit in the upper heat exchanger may be in fluid communication with a second heat exchange conduit in the lower heat exchanger. Each second heat exchange conduit in the upper heat exchanger may be in fluid communication with a first heat exchange conduit in the lower heat exchanger.

Each first heat exchange conduit may be in fluid communication with the inlet and each second heat exchange conduit may be in fluid communication with the outlet.

Optionally, more than one upper heat exchanger and/or more than one lower heat exchanger may be provided. The fluid flow to these further heat exchangers may be in parallel.

Optionally more heat exchangers may be connected with the fluid flow in series
A plurality of connecting pipes may connect the heat exchanger in fluid communication with the inlet and/or the outlet. For example, the plurality of connecting pipes may connect the first end of each heat exchange conduit to the inlet and/or the second end of each heat exchange conduit to the outlet.

A plurality of connecting pipes may connect the second end of each first heat exchange conduit to the first end of each second heat exchange conduit.

In an embodiment, the connecting pipes extending from the inlet to the heat exchanger may be thermally insulating (i.e. poor thermal conductors) and/or the plurality of connecting pipes may be substantially surrounded by thermal insulation. This may reduce heat loss from the fluid (or heat gain in the case of a cold fluid) before the fluid enters the heat exchanger. Such heat loss (or gain) would reduce the temperature difference between the hot and cold sides of the thermoelectric generator(s), lowering the output of the generator(s). Optionally, each of the connecting pipes may be thermally insulated.

The plurality of connecting pipes may not be identical (i.e. the plurality of connecting pipes may not all be the same shape, length, size or made of the same material(s)). The plurality of connecting pipes may comprise rigid pipes and/or flexible hoses. For example, the plurality of connecting pipes may have a cylindrical cross section, and/or a rectangular cross-section.

Optionally, the heat exchange conduits may be made from or comprise one or more of copper, silver, gold, aluminium, iron or one or more other materials, e.g. metals or alloys, which have a high thermal conductivity.

The thermoelectric generator(s) may be directly and/or indirectly coupled to the heat exchange conduits. For example, the thermoelectric generators may be adhered to at least a portion of at least two adjacent heat exchange conduits by a thermally conductive adhesive.

In some embodiments, a graphite based interface material may be provided between the heat exchanger contact surface of the thermoelectric generator(s) and the heat exchange conduits. Graphite has a particularly high in-plane thermal conductivity, which may help further neutralize any gradient or difference in the temperature of the hot side (or the cold side) of the thermoelectric generators.

The thermoelectric generators may be held in place by compressive clamping forces, optionally with the use of a thermal interface material such as a thermal grease or graphite sheet.

Additionally or alternatively, the thermoelectric generators may be soldered to at least a portion of at least two adjacent heat exchange conduits.

In some embodiments, some or all of the thermoelectric generators may comprise a thermally conductive housing.

Optionally, the heat recovery system may comprise a diffuser connected to the inlet (e.g. an inlet diffuser). The diffuser may comprise a plurality of apertures, wherein each aperture may be in fluid communication with at least one heat exchange conduit.

For example, each aperture of the inlet diffuser may receive one of a plurality of connecting pipes. Each of the connecting pipes extending from the inlet diffuser may be connected to the first end of a heat exchange conduit.

Optionally, the first end of each heat exchange conduit may be connected to the inlet diffuser, either directly or via a connecting pipe. In other embodiments, only the plurality of first heat exchange conduits may be in communication with the inlet diffuser.

Optionally, each of the first heat exchange conduits of the or each heat exchanger, e.g. two or more heat exchangers, may be connected to the inlet diffuser by a connecting pipe. In some embodiments, more than one inlet diffuser may be provided.

The inlet diffuser may be thermally insulating (i.e. a poor thermal conductor). Additionally or alternatively, the diffuser may be substantially surrounded by thermal insulation. In use, this may reduce heat dissipation from the fluid (or heat gain in the case of a cold fluid) before the fluid enters the heat exchanger.

Additionally or alternatively, the heat exchanger may comprise a diffuser connected to the outlet (e.g. an outlet diffuser). The outlet diffuser may comprise a plurality of apertures, wherein each aperture may be in fluid communication with at least one heat exchange conduit.

For example, each aperture of the outlet diffuser may receive one of a plurality of connecting pipes. Each of the connecting pipes extending from the outlet diffuser may be connected to the second end of a heat exchange conduit.

Optionally, the second end of each heat exchange conduit may be connected to the outlet diffuser, either directly or via a connecting pipe. In other embodiments, only the plurality of second heat exchange conduits may be in communication with the outlet diffuser.

Optionally, each of the second ends of the second heat exchange conduits of the or each heat exchanger, e.g. two or more heat exchangers, may be connected to the outlet diffuser, either directly or via by a connecting pipe. In some embodiments, more than one outlet diffuser may be provided. In other embodiments, only the plurality of second heat exchange conduits may be in communication with the outlet diffuser.

Optionally, the heat recovery system may comprise a control valve operable to regulate the fluid flow rate in the heat exchange conduits. The control valve may be located in the inlet diffuser.

Optionally, the heat recovery system may comprise at least one bypass channel in fluid communication with the inlet. The at least one bypass channel may be configured to bypass one or more of the thermoelectric generators.

The heat recovery system may comprise a valve operable to activate the bypass channel(s). The valve may be located in the inlet. The valve may be located in the inlet diffuser to control both the bypass channel activation and flow regulation to the heat exchange conduits. For example, when the valve is in an open position the heat exchange fluid may flow through one or more of the bypass channels. The bypass channel(s) may be activated (i.e. the valve may be opened) if the temperature and/or pressure of the fluid exceeds a predetermined threshold. This may prevent or minimise damage to the heat exchanger and/or the thermoelectric generators occurring, in use. In addition, the bypass may be activated when the back pressure must be minimised to minimise the impact on the fluid flow, such as in an automotive scenario during the time when maximum engine power is required.

In known heat recovery systems the thermoelectric generators near the inlet commonly reach their maximum operating temperature (also known as critical temperature) before the thermoelectric generators located further from the inlet. This is due to the gradient in the temperature of the hot side of the generators. This often causes the bypass channel to be activated, in use.

In the present invention, all, or almost all, of the thermoelectric generators should reach critical temperature at approximately the same time due to the reduced (or minimised) gradient in the temperature of the hot side of the generators. Thus, the present invention may prevent 'premature' activation of the bypass channel, which may increase the length of time that the heat recovery system can be in operation, thereby potentially increasing the total output power of the thermoelectric generator(s).

In some embodiments, the bypass channel may be configured to bypass the entire heat exchanger. For example, when the bypass channel is activated fluid may not be able to flow through any of the heat exchange conduits. This may provide a 'perfect' bypass.

In some embodiments, the heat exchanger may comprise at least one heat exchange conduit which is not in thermal contact with any thermoelectric generators. The at least one heat exchange conduit may form a bypass channel.

The at least one heat exchange conduit forming the bypass channel may comprise a fluid flow path having a lower resistance to fluid flow than fluid flow paths through the heat exchange conduits which are in contact with a thermoelectric generator.

In some embodiments, at least one wall of the heat exchange conduit(s) forming the bypass channel may be thermally insulated. This may prevent or reduce any heat exchange between the bypass channel and the heat exchanger contact surface of the thermoelectric generator(s).

Optionally, the bypass channel may be separated from the heat exchange conduits which are in thermal contact with the thermoelectric generator(s) by an air gap.

Optionally, the heat exchange conduits which are in thermal contact with one or more thermoelectric generators may comprise a plurality of heat exchange fins. The thermoelectric generators may be in thermal contact with at least one of the fins. In an embodiment, each heat exchange conduit may comprise the same number and/or density of thermally conductive fins.

The bypass channel(s) may contain no thermally conductive fins.

In some embodiments, more than one bypass channel may be provided. Each bypass channel may at least partially bypass one of the at least two heat exchangers.

In some embodiments, the heat exchanger surfaces on which the thermoelectric modules are sited may be substantially planar to enable good thermal contact and ease of achieving the required module clamping.

According to a second aspect of the invention, there is provided a thermoelectric heat recovery system comprising an inlet for receiving a fluid, an outlet, and N heat exchangers, where N≥2. The N heat exchangers may be located between, and in fluid communication with, the inlet and the outlet. Each heat exchanger comprises a plurality of heat exchange conduits. The plurality of heat exchange conduits may comprise one or more first fluid paths from the inlet to the outlet, the or each first fluid path passing through, in series, a heat exchange conduit in each of the N heat exchangers in a first sequence. The plurality of heat exchange conduits may comprise one or more second fluid paths from the inlet to the outlet, the or each second fluid path passing through, in series, a heat exchange conduit in each of the N heat exchangers in a second sequence, the second sequence being the reverse of the first sequence. In use, the fluid flows in a first direction through a given heat exchange conduit in a given heat exchanger and in a second direction opposite to the first direction through the or each heat exchange conduit adjacent the given heat exchange conduit in the given heat exchanger. The system may further comprise one or more thermoelectric generators. The or each thermoelectric generator has a heat exchanger contact surface which is in thermal contact with at least a portion of at least two adjacent heat exchange conduits, such that, in use, the heat exchanger contact surface forms the hot side or cold side of the thermoelectric generator.

In an embodiment the thermoelectric heat recovery system may comprise: an inlet for receiving a fluid; an outlet; N heat exchangers, wherein N≥2, located between, and in fluid communication with, the inlet and the outlet, each heat exchanger comprising a plurality of heat exchange conduits; one or more first fluid paths from the inlet to the outlet, the or each first fluid path passing through, in series, a heat exchange conduit in each of the N heat exchangers in a first sequence; one or more second fluid paths from the inlet to the outlet, the or each second fluid path passing through, in series, a heat exchange conduit in each of the N heat exchangers in a second sequence, the second sequence being the reverse of the first sequence; wherein, in use, the fluid flows in a first direction through a given heat exchange conduit in a given heat exchanger and in a second direction opposite to the first direction through the or each heat exchange conduit adjacent the given heat exchange conduit in the given heat exchanger; and one or more thermoelectric generators, wherein the or each thermoelectric generator has a heat exchanger contact surface which is in thermal contact with at least a portion of at least two adjacent heat exchange conduits, such that, in use, the heat exchanger contact surface forms the hot side or cold side of the thermoelectric generator.

Advantageously, this heat exchanger design presents a high cross-sectional area substantially perpendicular to the main fluid flow direction, due to the number of conduits acting in parallel.

In use, any given small volume of fluid passes through only one heat exchange conduit in a heat exchanger, and passes through a subsequent heat exchange conduit in the following downstream heat exchanger(s).

The system may include up to 50 heat exchangers, up to or at least 20 heat exchangers, or up to or at least 10 heat exchangers.

For instance, the number N of heat exchangers in the system may be 2, or 3, or 4, or 5, or 6, or 7, or 8, or 9, or 10.

The number N of heat exchangers may be an even number, as this may simplify the required fluid interconnections to the inlet and/or outlet.

In some embodiments, the thermoelectric heat recovery system may comprise a plurality of thermoelectric generators. Optionally, the thermoelectric generator(s) may be in thermal contact with all of the heat exchange conduits along substantially the entire length of the heat exchange conduits.

The or each thermoelectric generator has a heat exchanger contact surface which is in thermal contact with at least a portion of at least two adjacent heat exchange conduits of a given heat exchanger.

If the fluid flowing through the heat exchange conduits is a hot fluid relative to the surrounding ambient air (or other fluid) then the heat exchanger contact surface(s) in thermal contact with at least a portion of at least two adjacent heat exchange conduits forms, in use, the hot side of the thermoelectric generator(s).

Conversely, if the fluid flowing through the heat exchange conduits is a cold fluid relative to the surrounding ambient air (or other fluid) then the heat exchanger contact surface(s) in thermal contact with at least a portion of at least two adjacent heat exchange conduits forms, in use, the cold side of the thermoelectric generator(s).

The heat recovery system of the present invention reduces the difference in the temperature of the heat exchanger contact surfaces of the thermoelectric generators. In other words, the present invention reduces the difference between the temperature of the hot side (or alternatively cold side) between each of the thermoelectric generators.

For a heat recovery system using a hot fluid the temperature of the fluid will decrease due to thermal losses as the fluid flows along each heat exchange conduit from the inlet towards the outlet. The reverse is true for a heat recovery system using a cold fluid. Thus, as each thermoelectric generator has a heat exchanger contact surface which is in thermal contact with at least a portion of at least two adjacent heat exchange conduits, and as the fluid flows in opposite directions in adjacent conduits, these thermal losses (or gains) are averaged out.

As each thermoelectric generator has a heat exchanger contact surface which is in thermal contact with at least a portion of at least two adjacent heat exchange conduits, and as the two adjacent conduits comprise part of the first and second flow path, these thermal losses (or gains) are averaged out.

For example, a given heat exchange conduit in a given heat exchanger that comprises an upstream end of the first fluid path is adjacent another conduit in the given heat exchanger that comprises a downstream end of the second fluid path, and vice versa. Similarly, a given heat exchange conduit in a given heat exchanger that comprises the middle of the first fluid path is adjacent another conduit in the given heat exchanger that comprises the middle of the second fluid path. As such, at substantially any point along the first or second fluid path from the inlet to the outlet, the average temperature of the two adjacent conduits in a given heat exchanger may be substantially the same.

This results in each heat exchanger contact surface having substantially the same average temperature (or surface temperature). Hence, in use, the hot side (or cold side) of each thermoelectric generator may be at a similar, or even substantially the same, temperature.

Advantageously, reducing the gradient in the temperature of the hot side (or cold side) of the thermoelectric generators may also reduce any differential thermal expansion of the heat exchanger.

In some embodiments, the gradient in the temperature of the hot side (or cold side) of the thermoelectric generators may be minimised and/or the gradient may be substantially neutralised.

The present invention may be advantageous compared with heat recovery systems which optimise the distribution of heat exchange fins in the heat exchange conduit, e.g. US20130340801. For example, in US20130340801 the heat exchange fin distribution is optimised for a certain flow rate and temperature of the fluid. In practice, the flow rate and temperature of the fluid through the heat exchanger is not constant, thus the gradient in the temperature of the hot side of the thermoelectric generators would not be cancelled unless the flow rate and temperature of the fluid were strictly controlled. This is not required in the present invention, as a change in the flow rate or inlet temperature of the fluid will affect all of the thermoelectric generators equally.

In addition, heat exchangers used with a hot fluid typically have a low thermal resistance (i.e. high rate of heat transfer to the hot side of the thermoelectric generators), even without the use of fins. It can therefore be very difficult for heat exchange fins to effectively adjust the amount of heat transferred from the fluid to the thermoelectric generators. The use of heat exchange fins, particularly if they are very densely packed, can also increase thermal stresses in the heat exchanger and the pressure drop.

Optionally, the length of each heat exchange conduit may be substantially the same.

In some embodiments, some or all of the plurality of heat exchange conduits may be substantially parallel to each other along at least a portion of their lengths. Additionally or alternatively, at least two adjacent heat exchange conduits may be wound helically around each other along at least a portion of their lengths.

Optionally, each pair of adjacent heat exchange conduits may comprise at least one common wall. The at least one common wall may have a high thermal conductivity and/or low thermal resistance.

In some embodiments, each heat exchange conduit in a given heat exchanger may comprise a first end and a second end, wherein, in use, fluid may flow from the first end of a heat exchange conduit to the second end of the heat exchange conduit. The heat exchange conduits in a given heat exchanger may be arranged such that the first end of a given heat exchange conduit is adjacent to the second end of the or each adjacent heat exchange conduit.

The first end of each heat exchange conduit may be in fluid communication with the inlet. The second end of each heat exchange conduit may be in fluid communication with the outlet.

Optionally, each of the N heat exchangers may comprise a plurality of first heat exchange conduits and a plurality of second heat exchange conduits, the direction of fluid flow, in use, through the first heat exchange conduits being opposite that through the second heat exchange conduits. Each first heat exchange conduit may be positioned adjacent to at least one second heat exchange conduit. The first end of each first heat exchange conduit may be adjacent to the second end of a second heat exchange conduit.

The plurality of first heat exchange conduits in each of the N heat exchangers may comprise the one or more first fluid paths, and the plurality of second heat exchange conduits in each of the N heat exchangers may comprise the one or more second fluid paths, or vice versa.

In some embodiments, at least one given first heat exchange conduit in a given heat exchanger may be in fluid communication with one of the second heat exchange conduits in a subsequent heat exchanger such that the second heat exchange conduit in the subsequent heat exchanger is located downstream of the given first heat exchange conduit in the given heat exchanger.

The first end of each first heat exchange conduit in at least two, e.g. all, of the N heat exchangers may be in fluid communication with the inlet. Additionally or alternatively, the second end of each second heat exchange conduit in at least two, e.g. all, of the N heat exchanger may be in fluid communication with the outlet. For example, in use, fluid may flow from the inlet through a given first heat exchange conduit in a given heat exchanger, then through a given second heat exchange conduit in a subsequent heat exchanger, then to the outlet.

Optionally, the N heat exchangers may be arranged in layers (e.g. stacked one disposed at least partially above another or one surrounding another). In other embodiments, at least two of the N heat exchangers may be disposed adjacent to each other.

At least a portion of at least two adjacent heat exchange conduits in each heat exchanger in the layers/stack may be at least partially in thermal in contact with a heat exchanger contact surface of the or each respective thermoelectric generator.

Each heat exchanger in the layers/stack may have one or more thermoelectric generators associated with it. The or each thermoelectric generator may comprise a cold side. The cold side of the or each thermoelectric generator may be or comprise a cold plate. Each heat exchanger in the layers/stack may have one or more thermoelectric generators disposed between them.

Advantageously, the arrangement of the heat exchangers may improve, or maximise, the power output of the heat recovery system for the amount of space available.

The N heat exchangers may be at least partially in thermal contact with each other.

Some or all of the N heat exchangers may be in fluid communication with one another.

For example, the heat recovery system may comprise an upper heat exchanger and a lower heat exchanger. The upper and lower heat exchangers may each comprise a plurality of first heat exchange conduits and a plurality of second heat exchange conduits. Each first heat exchange conduit may be adjacent to at least one second heat exchange conduit. In use, fluid may flow in an opposite direction in the first heat exchange conduits compared with the second heat exchange conduits.

For example, each first heat exchange conduit in the upper heat exchanger may be in fluid communication with a second heat exchange conduit in the lower heat exchanger. Each second heat exchange conduit in the upper heat exchanger may be in fluid communication with a first heat exchange conduit in the lower heat exchanger.

Each first heat exchange conduit in the upper heat exchanger may be in fluid communication with the inlet and each second heat exchange conduit in the lower heat exchanger may be in fluid communication with the outlet, or vice versa.

Optionally, more than one upper heat exchanger and/or more than one lower heat exchanger may be provided. The fluid flow to these further heat exchangers may be in parallel.

A plurality of connecting pipes may connect at least two of the N heat exchangers in fluid communication with the inlet and/or the outlet. For example, the plurality of connecting pipes may connect the first end of the/each first heat exchange conduit in at least two of the N heat exchangers to the inlet. Additionally or alternatively, the plurality of connecting pipes may connect the second end of the/each second heat exchange conduit in at least two of the N heat exchangers to the outlet.

A plurality of connecting pipes may connect the second end of each first heat exchange conduit in a given heat exchanger to the first end of each second heat exchange conduit in a subsequent downstream heat exchanger in the series.

Advantageously, the system comprises a low number of curves in series, and the connecting pipes between conduits in the first and/or second fluid path have a higher radius of curvature due to the fluid communication between different heat exchangers in series rather than within a single heat exchanger. This means that the present invention may have a significantly lower resistance to flow and therefore lower back pressure compared to conventional systems, while reducing the temperature gradients. This is achieved whilst obtaining a moderately even fluid flow distribution in a relatively simple, compact design.

The back pressure is a function of the internal cross-sectional area of the/each connecting pipe and also the radius of curvature of the/each connecting pipe. The radius of curvature may be defined by the centre line radius of the bend of the/each connecting pipe. The connecting pipes may have a substantially circular internal cross-section. The cross-sectional area of the/each connecting pipe is related to the respective internal diameter of the/each connecting pipe. In an embodiment, the radius of curvature of the/each connecting pipe may be substantially equal to, or greater than, the respective internal diameter of the/each connecting pipe. A similar constraint may be applied to connecting pipes of non-circular internal cross-section (e.g. square or elliptical).

In an embodiment, the connecting pipes extending from the inlet to the heat exchanger may be thermally insulating (i.e. poor thermal conductors) and/or the plurality of connecting pipes may be substantially surrounded by thermal insulation. This may reduce heat loss from the fluid (or heat gain in the case of a cold fluid) before the fluid enters the heat exchanger. Such heat loss (or gain) would reduce the temperature difference between the hot and cold sides of the thermoelectric generator(s), lowering the output of the generator(s). Optionally, each of the connecting pipes may be thermally insulated.

The plurality of connecting pipes may not be identical (i.e. the plurality of connecting pipes may not all be the same shape, length, size or made of the same material(s)). The plurality of connecting pipes may comprise rigid pipes and/or flexible hoses. For example, the plurality of connecting pipes may have a cylindrical cross section, and/or a rectangular cross-section.

Optionally, the heat exchange conduits may be made from or comprise one or more of copper, silver, gold, aluminium, iron or one or more other materials, e.g. metals or alloys, which have a high thermal conductivity.

The thermoelectric generator(s) may be directly and/or indirectly coupled to the heat exchange conduits. For example, the thermoelectric generators may be adhered to at least a portion of at least two adjacent heat exchange conduits by a thermally conductive adhesive.

In some embodiments, a graphite based interface material may be provided between the heat exchanger contact surface of the thermoelectric generator(s) and the heat exchange conduits. Graphite has a particularly high in-plane thermal conductivity, which may help further neutralize any gradient or difference in the temperature of the hot side (or the cold side) of the thermoelectric generators.

The thermoelectric generators may be held in place by compressive clamping forces, optionally with the use of a thermal interface material such as a thermal grease or graphite sheet.

Additionally or alternatively, the thermoelectric generators may be soldered to at least a portion of at least two adjacent heat exchange conduits.

In some embodiments, some or all of the thermoelectric generators may comprise a thermally conductive housing.

Optionally, the heat recovery system may comprise a diffuser connected to the inlet (e.g. an inlet diffuser). The diffuser may comprise a plurality of apertures, wherein each aperture may be in fluid communication with at least one heat exchange conduit in a given heat exchanger.

For example, each aperture of the inlet diffuser may receive one of a plurality of connecting pipes. Each of the connecting pipes extending from the inlet diffuser may be connected to the first end of a heat exchange conduit.

Optionally, the first end of each first heat exchange conduit in at least two of the N heat exchangers may be connected to the inlet diffuser, either directly or via a connecting pipe.

In some embodiments, more than one inlet diffuser may be provided.

The inlet diffuser may be thermally insulating (i.e. a poor thermal conductor). Additionally or alternatively, the diffuser may be substantially surrounded by thermal insulation. In use, this may reduce heat dissipation from the fluid (or heat gain in the case of a cold fluid) before the fluid enters the heat exchanger.

Additionally or alternatively, the heat exchanger may comprise a diffuser connected to the outlet (e.g. an outlet diffuser). The outlet diffuser may comprise a plurality of apertures, wherein each aperture may be in fluid communication with at least one heat exchange conduit in a given heat exchanger.

For example, each aperture of the outlet diffuser may receive one of a plurality of connecting pipes. Each of the connecting pipes extending from the outlet diffuser may be connected to the second end of a heat exchange conduit.

Optionally, the second end of each second heat exchange conduit in at least two of the N heat exchangers may be connected to the outlet diffuser, either directly or via a connecting pipe.

In some embodiments, more than one outlet diffuser may be provided.

Optionally, the heat recovery system may comprise a control valve operable to regulate the fluid flow rate in the heat exchange conduits. The control valve may be located in the inlet diffuser.

Optionally, the heat recovery system may comprise at least one bypass channel in fluid communication with the inlet. The at least one bypass channel may be configured to bypass one or more of the thermoelectric generators.

The heat recovery system may comprise a valve operable to activate the bypass channel(s). The valve may be located in the inlet. The valve may be located in the inlet diffuser to control both the bypass channel activation and flow regulation to the heat exchange conduits. For example, when the valve is in an open position the heat exchange fluid may flow through one or more of the bypass channels. The bypass channel(s) may be activated (i.e. the valve may be opened) if the temperature and/or pressure of the fluid exceeds a predetermined threshold. This may prevent or minimise damage to the heat exchanger and/or the thermoelectric generators occurring, in use. In addition, the bypass may be activated when the back pressure must be minimised to minimise the impact on the fluid flow, such as in an automotive scenario during the time when maximum engine power is required.

In known heat recovery systems the thermoelectric generators near the inlet commonly reach their maximum operating temperature (also known as critical temperature) before the thermoelectric generators located further from the inlet. This is due to the gradient in the temperature of the hot side of the generators. This often causes the bypass channel to be activated, in use.

In the present invention, all, or almost all, of the thermoelectric generators should reach critical temperature at approximately the same time due to the reduced (or minimised) gradient in the (average) temperature of the hot side of the generators. Thus, the present invention may prevent 'premature' activation of the bypass channel, which may increase the length of time that the heat recovery system can be in operation, thereby potentially increasing the total output energy of the thermoelectric generator(s).

In some embodiments, the bypass channel may be configured to bypass the entire heat exchanger or heat exchangers. For example, when the bypass channel is activated fluid may not be able to flow through any of the heat exchange conduits in a given heat exchanger or heat exchangers. This may provide a 'perfect' bypass.

In some embodiments, one or more of the N heat exchangers may comprise at least one heat exchange conduit which is not in thermal contact with any thermoelectric generators. The at least one heat exchange conduit may form a bypass channel.

The at least one heat exchange conduit forming the bypass channel may comprise a fluid flow path having a lower resistance to fluid flow than fluid flow paths through the heat exchange conduits which are in thermal contact with a thermoelectric generator.

In some embodiments, at least one wall of the heat exchange conduit(s) forming the bypass channel may be thermally insulated. This may prevent or reduce any heat exchange between the bypass channel and the heat exchanger contact surface of the thermoelectric generator(s).

Optionally, the bypass channel may be separated from the heat exchange conduits which are in thermal contact with the thermoelectric generator(s) by an air gap.

Optionally, the heat exchange conduits which are in thermal contact with one or more thermoelectric generators may comprise a plurality of heat exchange fins. The thermoelectric generators may be in thermal contact with at least one of the fins. In an embodiment, each heat exchange conduit may comprise the same number and/or density of thermally conductive fins.

The bypass channel(s) may contain no thermally conductive fins.

In some embodiments, more than one bypass channel may be provided. Each bypass channel may at least partially bypass one or more of the N heat exchangers.

In some embodiments, the heat exchanger surfaces on which the thermoelectric modules are sited may be substantially planar to enable good thermal contact and ease of achieving the required module clamping.

According to a third aspect of the invention, there is provided an exhaust system comprising a heat recovery system of the first aspect of the invention and/or a heat recovery system of the second aspect of the invention, wherein the heat exchange fluid is an exhaust fluid and the heat exchanger contact surface(s) form the hot side of the thermoelectric generator(s).

Optionally, the exhaust system may be an automotive exhaust system and/or other internal combustion engine exhaust system.

The exhaust system may be a maritime or aerospace exhaust system. The exhaust system may be coupled to an industrial, commercial or residential building or structure.

According to a fourth aspect of the invention, there is provided a structure such as a building or a vehicle comprising or having coupled thereto at least one heat recovery system according to the first aspect of the invention and/or at least one heat recovery system according to the second aspect of the invention.

For example, the vehicle may be a car, lorry, motorcycle, bus, train, aeroplane, helicopter and/or ship.

The heat recovery system may be configured to be used in one or more of the vehicle exhaust system and/or the engine coolant system (e.g. radiator).

The building may comprise for example: an industrial building such as a factory, an incinerator or a power plant; a commercial building; or a residential building.

According to a fifth aspect of the invention, there is provided a method of converting waste heat into electricity, the method comprising:
providing a heat recovery system according to the first aspect of the invention;
providing a waste hot fluid or a waste cold fluid;
channelling said waste hot fluid or waste cold fluid though the heat exchange conduits of the heat exchanger(s) of the heat recovery system; and
generating electricity using the thermoelectric generator(s) of the heat recovery system.

The generated electricity may be used to provide electrical power locally, e.g. within a structure such as a building or vehicle fitted with the heat recovery system of the invention, and/or the generated electricity may be transmitted to a remote location.

The method may comprise using a heat recovery system of any embodiment of the present invention.

The method may include bypassing one or more of the thermoelectric generators if the temperature and/or pressure of the fluid exceed(s) a predetermined threshold. Optionally, the method may include controlling the flow rate of the fluid in the heat exchange conduits using the valve.

According to a sixth aspect of the invention, there is provided a method of converting waste heat into electricity, the method comprising:
providing a heat recovery system according to the second aspect of the invention;
providing a waste hot fluid or a waste cold fluid;
channelling said waste hot fluid or waste cold fluid though the heat exchange conduits of the N heat exchangers of the heat recovery system; and
generating electricity using the thermoelectric generator(s) of the heat recovery system.

The generated electricity may be used to provide electrical power locally, e.g. within a structure such as a building or vehicle fitted with the heat recovery system of the invention, and/or the generated electricity may be transmitted to a remote location.

The method may comprise using a heat recovery system of any embodiment of the present invention.

The method may include bypassing one or more of the thermoelectric generators if the temperature and/or pressure of the fluid exceed(s) a predetermined threshold. Optionally, the method may include controlling the flow rate of the fluid in the heat exchange conduits using the valve.

Embodiments of the invention will now be described, by way of example only, with reference to the accompanying drawings, in which:
**Figure 1** shows a schematic illustration of the top view of a heat exchanger according to an embodiment of the invention;
**Figure 2** shows a schematic illustration of the heat exchanger of Figure 1 including a plurality of connecting pipes;
**Figure 3** shows a schematic illustration of an upper and lower heat exchanger according to an embodiment of the invention;
**Figure 4** shows an example temperature distribution for the heat exchanger system as shown in Figure 3;
**Figure 5** shown an example temperature distribution for fluid passing through three heat exchangers in series;
**Figure 6** shows an embodiment of a heat recovery system of the present invention (without thermoelectric generators);
**Figure 7** shows the system of Figure 6 including a plurality of thermoelectric generators;
**Figure 8** shows a further embodiment of a heat recovery system of the present invention (without thermoelectric generators);
**Figure 9** shows a further embodiment of a heat recovery system of the present invention (without thermoelectric generators); and
**Figure 10** shows a further embodiment of a heat recovery system of the present invention (without thermoelectric generators).

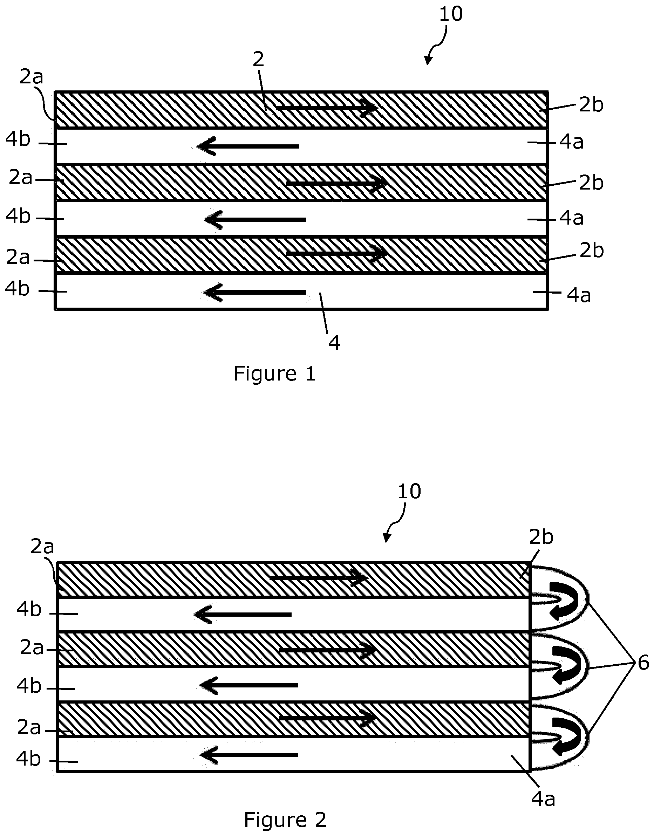

Figure 1 shows a heat exchanger 10 for use in a heat recovery system according to an embodiment of the invention. The heat exchanger 10 comprises six heat exchange conduits comprising three first heat exchange conduits 2 and three second heat exchange conduits 4. The three first heat exchange conduits 2 are alternate with the three second heat exchange conduits 4. The heat exchange conduits are arranged such that each first heat exchange conduit 2 is adjacent, and runs parallel, to at least one second heat exchange conduit 4. While six heat exchange conduits are shown in Figure 1, it will be appreciated that the heat exchanger 10 may comprise two or more heat exchange conduits, i.e. at least one first heat exchange conduit and at least one second heat exchange conduit.

Each first heat exchange conduit 2 comprises a first end 2a and a second end 2b. Each second heat exchange conduit 4 comprises a first end 4a and a second end 4b. The first ends 2a of the first heat exchange conduits 2 are adjacent the second ends 4b of the second heat exchange conduits 4, and vice versa. In use, fluid flows through the first and second heat exchange conduits from the first ends 2a, 4a to the second ends 2b, 4b. The fluid flow direction is indicated by the arrows in Figure 1. As illustrated, the direction of fluid flow alternates between each adjacent heat exchange conduit 2, 4 in the heat exchanger 10.

In some embodiments, the first ends 2a, 4a of the heat exchange conduits 2, 4 may be in fluid communication with an inlet, wherein the inlet receives, in use, a hot or cold fluid (e.g. an exhaust fluid or a coolant fluid).

The second ends 2b, 4b of the heat exchange conduits 2, 4 may be in fluid communication with an outlet. The outlet may provide an output path for the fluid after it has passed through the heat recovery system.

Alternatively, as shown in Figure 2, the second end 2b of each of the plurality of first heat exchange conduits 2 may be connected by a connecting pipe 6 to the first end 4a of one of the plurality of second heat exchange conduits 4, in this case a neighbouring second heat exchange conduit 4. Thus, in use, fluid may flow from an inlet through each of the first conduits 2, through each connecting pipe 6, through each of the second conduits 4 and towards an outlet. The fluid flow direction is indicated by the arrows in Figure 2.

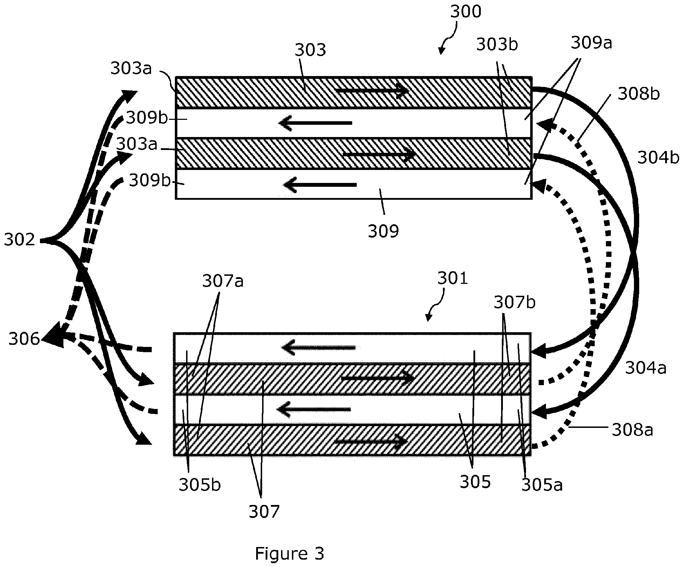

Figure 3 shows two heat exchangers arranged as an upper heat exchanger 300 and a lower heat exchanger 301 for use in a heat recovery system according to an embodiment of the invention. Each heat exchanger 300,301 comprises four heat exchange conduits comprising two first heat exchange conduits 303; 307 and two second heat exchange conduits 309; 305. The two first heat exchange conduits 303; 307 are alternate with the two second heat exchange conduits 309; 305 in each heat exchanger 300; 301. The heat exchange conduits are arranged such that each first heat exchange conduit 303, 307 is adjacent, and runs parallel, to at least one second heat exchange conduit 309, 305, and vice versa. Although each heat exchanger 300,301 is shown with four heat exchange conduits in Figure 3, it will be appreciated that each heat exchanger 300, 301 may comprise two or more heat exchange conduits, i.e. at least one first heat exchange conduit and at least one second heat exchange conduit.

Each first heat exchange conduit 303, 307 comprises a first end 303a, 307a and a second end 303b, 307b. Each second heat exchange conduit 309, 305 comprises a first end 309a, 305a and a second end 309b, 305b. The first ends 303a, 307a of the first heat exchange conduits 303, 307 are adjacent the second ends 309b, 305b of the second heat exchange conduits 309, 305, and vice versa. In use, fluid flows through the first and second heat exchange conduits from the first ends 303a, 307a, 309a, 305a to the second ends 303b, 307b, 309b, 305b. The fluid flow direction is indicated by the arrows in the heat exchange conduits in Figure 3. As illustrated, the direction of fluid flow alternates between each adjacent heat exchange conduit 303, 309 or 305, 307 in the heat exchangers 300 or 301.

The first ends 303a, 307a of the first heat exchange conduits 303, 307 are in fluid communication with an inlet 302. The inlet 302 receives, in use, a hot or cold fluid (e.g. an exhaust fluid or a coolant fluid). A manifold and/or a plurality of connecting pipes provides fluid communication between the inlet 302 and the first ends 303a, 307a of the first heat exchange conduits 303, 307.

The second ends 305b, 309b of the second heat exchange conduits 305, 309 are in fluid communication with an outlet 306. The outlet 306 provides an output path for the fluid after it has passed through the heat recovery system. A manifold and/or a plurality of connecting pipes provides fluid communication between the second ends 305b, 309b of the second heat exchange conduits 305, 309 and the outlet 306.

Each of the second ends 303b of the first heat exchange conduits 303 in the upper heat exchanger 300 is in fluid communication with the first end 305a of one of the second heat exchange conduits 305 in the lower heat exchanger 301 via a curved pipe 304a, 304b.

Each of the second ends 307b of the first heat exchange conduits 307 in the lower heat exchanger 301 is in fluid communication with the first end 309a of one of the second heat exchange conduits 309 in the upper heat exchanger 300 via a curved pipe 308a, 308b.

In the first way (first fluid path) a given small volume of fluid passes from the inlet 302, through the first end 303a of the first heat exchange conduit 303 in the upper heat exchanger 300 to the second end 303b of the first heat exchange conduit 303 in the upper heat exchanger 300, through curved pipe 304a, 304b to the first end 305a of the second heat exchange conduit 305 in the lower heat exchanger 301 to the second end 305b of the second heat exchange conduit 305 in the lower heat exchanger 301 and then to the outlet 306.

In the second way (second fluid path), a given small volume of fluid passes from the inlet 302, through the first end 307a of the first heat exchange conduit 307 in the lower heat exchanger 301 to the second end 307b of the first heat exchange conduit 307 in the lower heat exchanger 301, through curved pipe 308a, 308b to the first end 309a of the second heat exchange conduit 309 in the upper heat exchanger 300 to the second end 309b of the second heat exchange conduit 309 in the upper heat exchanger 300 and then to the outlet 306. Thus, in use, any small volume of fluid only passes through one heat exchange conduit in each heat exchanger.

As such, any small volume of fluid may pass from the inlet to the outlet through the two heat exchangers in series in a first sequence (e.g. from heat exchanger 300 to heat exchanger 301) via a first fluid path, or a second sequence via a second fluid path, the second sequence being the reverse of the first sequence (e.g. from heat exchanger 301 to heat exchanger 300).

Fluid communication between heat exchange conduits in the upper 300 and lower 301 heat exchanger is achieved using curved connecting pipes. Due to the separation between different heat exchangers, the connecting pipes 304, 308 may have a significantly higher radius of curvature than that of the connecting pipes 6 within one heat exchanger (e.g. as shown in figure 2). Advantageously, this may reduce the resistance or restriction to fluid flow in the fluid path(s) through the heat exchangers and the associated back pressure from the heat exchangers.

The back pressure is a function of the internal cross-sectional area of the/each connecting pipe 304, 308 and also their respective radius of curvature. The cross-sectional area is related to the internal diameter of the connecting pipe 304, 308. In an embodiment, the radius of curvature of the/each connecting pipe 304, 308 (defined by the centre line radius of the bend) is greater than the internal diameter of the/each connecting pipe 304, 308. It will be understood that a similar constraint can be applied to pipes of non-circular cross-section.

Although figure 3 shows a system comprising two heat exchangers in series, in other embodiments the system may comprise any number N of heat exchangers in series, where N ≥ 2. For example, the system may comprise 3, 4, 5, 6, 7, 8, 9, or 10 heat exchangers in series. Any small volume of fluid passes once through each heat exchanger in the series.

The system of N heat exchangers may comprise one or more first fluid paths and one or more second fluid paths. Each of the one or more first and second fluid paths may comprise a distinct heat exchange conduit in each of the N heat exchangers in the series.

For example, if i is an integer from 1 to N, a given heat exchanger in the system may be the ith heat exchanger in the first fluid path and the [(N+1)-i]th heat exchanger in the second fluid path.

In use, some fluid passes from the inlet to the outlet through the heat exchangers in series in a first sequence via a first fluid path, and some fluid passes from the inlet to the outlet through the heat exchangers in series in a second sequence via a second fluid path, the second sequence being the reverse of the first sequence.

With reference to figure 1, figure 2 or figure 3, a plurality of thermoelectric generators (not shown) are arranged to be in thermal contact with the or each heat exchanger 10, 300, 301, wherein a heat exchanger contact surface of each thermoelectric generator is in thermal contact with at least a portion of at least two adjacent heat exchange conduits (i.e. a portion of at least one first heat exchange conduit 2, 303, 307 and a portion of at least one second heat exchange conduit 4, 305, 309).

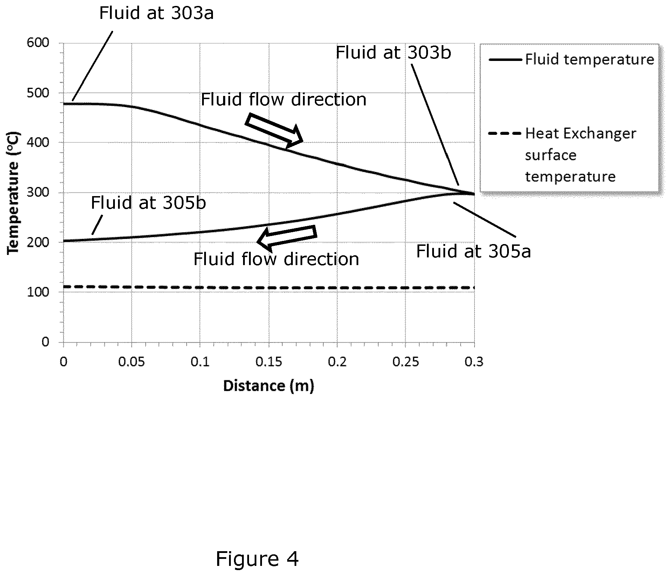

Figure 4 shows an example temperature profile for the heat exchanger system of Figure 3. It shows the average fluid temperature in the first heat exchange conduit 303 of the upper heat exchanger 300 and the average fluid temperature in the second heat exchange conduit 305 of the lower heat exchanger 301. The fluid enters the first end 303a of the first heat exchange conduit 303 in the upper heat exchanger 300 at a high temperature (fluid at 303a), and drops in temperature as the distance along the heat exchanger increases, until it exits the upper heat exchanger 300 via the second end 303b of the first heat exchange conduit 303 (fluid at 303b). The fluid then enters the lower heat exchanger 301, in the first end 305a of the second heat exchange conduit 305 (fluid at 305a) and further drops in temperature until it exits the lower heat exchanger 301 via the second end 305b of the second heat exchange conduit 305 (fluid at 305b). Similar temperature profiles will occur for the fluid passing through the first heat exchange conduit 307 in the lower heat exchanger 301 followed by the second heat exchange conduit 309 in the upper heat exchanger 300.

The different direction of flow through the heat exchangers in the first and second heat exchange conduits results in a heat exchanger surface temperature (dashed line) that is substantially more uniform, with a smaller temperature gradient, than the fluid temperature gradient in either of the heat exchange conduits 303, 305. This results in a smaller temperature gradient on the hot side of the thermoelectric generator(s) which are thermally in contact with the heat exchangers.

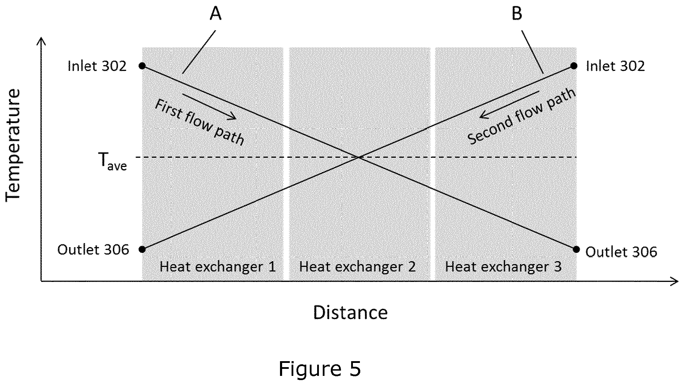

This effect is further shown schematically in figure 5 in the case of three heat exchangers in series. Figure 5 shows the fluid temperature along the first flow path A and second fluid path B between the inlet 302 and the outlet 306 as fluid flows through adjacent heat exchange conduits in a first, second, and third heat exchanger in a first sequence and a second (reverse) sequence, respectively. The flow direction is indicated by the arrows.

As shown, a given heat exchange conduit in the first heat exchanger comprises an upstream end of the first fluid path A and the or each adjacent heat exchange conduit comprises a downstream end of the second fluid path B. A given heat exchange conduit in the second heat exchanger comprises a middle portion of the first fluid path A and the or each adjacent heat exchange conduit comprises a middle portion of the second fluid path B. A given heat exchange conduit in the third heat exchanger comprises a downstream end of the first fluid path A and the or each adjacent heat exchange conduit comprises an upstream end of the second fluid path B. As such, at substantially any point along the first or second fluid path from the inlet to the outlet, the average temperature of the two adjacent conduits in a given heat exchanger is substantially the same.

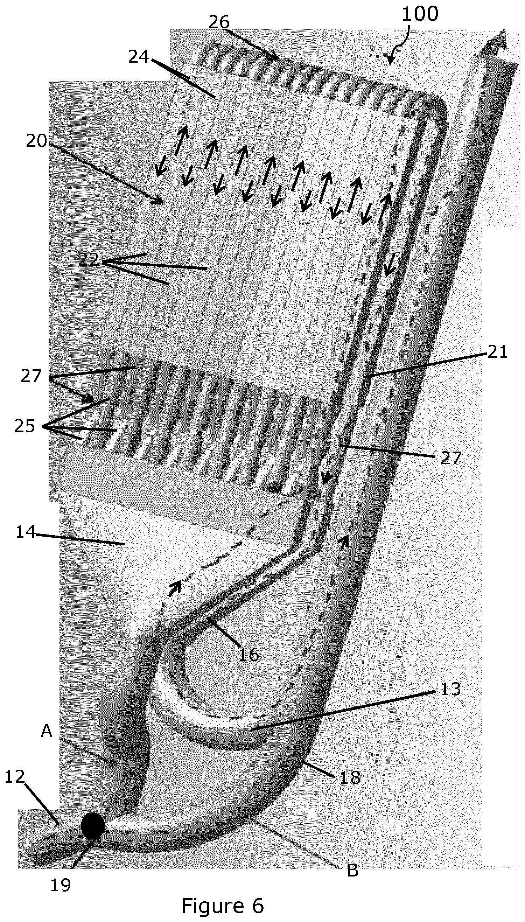

Figure 6 shows a heat recovery system 100 according to an embodiment of the invention. The thermoelectric generators are not shown to more clearly show the layout of the heat exchange conduits. The system comprises an inlet 12 for receiving a heat exchange fluid (e.g. a hot or cold fluid) and an outlet 13 for emitting the fluid.

An inlet diffuser 14 is connected to the inlet 12 and an outlet diffuser 16 is connected to the outlet 13.

In this example, the heat recovery system 100 comprises two heat exchangers, an upper heat exchanger 20 and a lower heat exchanger 21. Both heat exchangers 20, 21 may be equivalent or similar to heat exchangers 10, 300, 301 in Figures 1 to 3. In use, fluid flows in opposite directions in each adjacent heat exchange conduit 22, 24 of both the upper 20 and lower 21 heat exchangers. The heat exchange conduits 22, 24 may comprise a plurality of thermally conductive fins.

Each first heat exchange conduit 22 of the upper heat exchanger 20 is connected by a connecting pipe 26 to a second heat exchange conduit 24 of the lower heat exchanger 21. Similarly, each second heat exchange conduit 24 of the upper heat exchanger 20 is connected by a connecting pipe 26 to a first heat exchange conduit 22 of the lower heat exchanger 21.

In Figure 6, the heat exchange conduits are arranged such that each heat exchange conduit of the upper heat exchanger 20 is connected to the heat exchange conduit of the lower heat exchanger 21 that is located directly underneath it. Thus, the heat exchange conduits are connected in a series of adjacent pairs, each pair comprising one heat exchange conduit from the upper heat exchanger 20 and one heat exchange conduit from the lower heat exchanger 21. However, in other examples the heat exchange conduits may be connected differently.

The first heat exchange conduits 22 of the upper and lower heat exchangers 20, 21 are connected by connecting pipes 25 to the inlet diffuser 14. The second heat exchange conduits 24 of the upper and lower heat exchangers 20, 21 are connected by connecting pipes 27 to the outlet diffuser 16.

The connecting pipes 25 and 26 are thermally insulated. For example, the connecting pipes 25, 26 may be insulated copper pipes, or flexible hoses comprising thermally insulating walls. In order to reduce costs, connecting pipes 27 may not be thermally insulated, as it may not be important to prevent heat transfer from the fluid after it has passed through the heat exchangers 20, 21.

An example of a heat recovery fluid flow path through the heat exchangers 20, 21 is shown by path A.

A bypass channel 18 is in fluid communication with the inlet 12 and the outlet 13. In this example the bypass channel 18 bypasses the upper and lower heat exchangers 20, 21. The bypass fluid flow path is shown as path B in Figure 6.

A valve 19 located in the inlet 12 is operable to activate (i.e. allow fluid to flow through) the bypass channel 18. For example, when the valve 19 is in a closed position fluid may only flow from the inlet 12 to the inlet diffuser 14. When the valve 19 is in an open position fluid may only flow from the inlet 12 through the bypass channel 18. Thus, in Figure 3 the bypass channel 18 forms a 'perfect' bypass.

The bypass channel 18 may be activated if the temperature and/or pressure of the fluid and/or the temperature of the thermoelectric generators exceed(s) a predetermined threshold (e.g. a critical temperature and/or pressure). The bypass channel 18 may be activated remotely, automatically and/or manually.

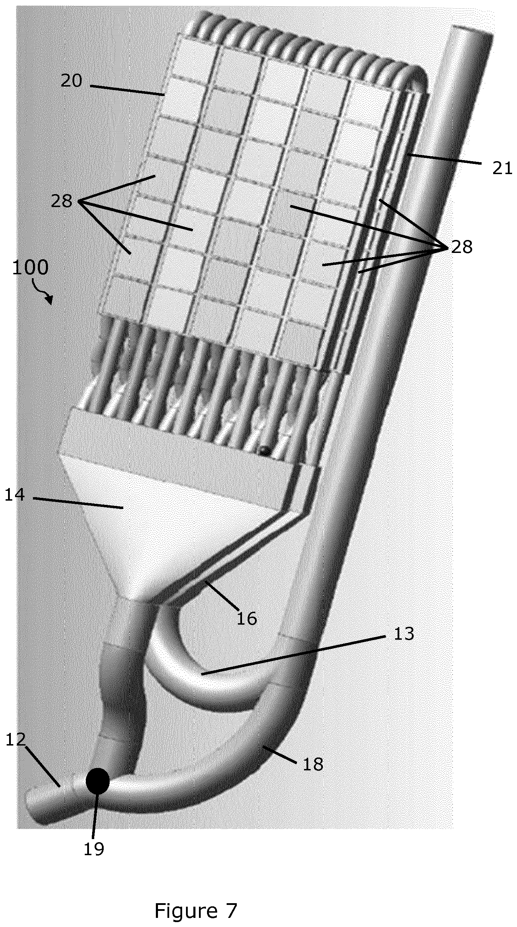

Figure 7 shows the heat recovery system 100 of Figure 6 including a plurality of thermoelectric generators 28. Each thermoelectric generator 28 has a heat exchanger contact surface which is in thermal contact with at least a portion of at least two adjacent heat exchange conduits 22, 24 of the upper or lower heat exchanger 20, 21. The cooling system of the cold side of the thermoelectric generator(s) is not shown for clarity, but optionally may comprise liquid cooling.

Using two (or more) heat exchangers may increase the power output of the system, as thermoelectric generators may be provided on each level. By stacking the heat exchangers 20, 21 the spatial requirements of the heat recovery system may not be significantly increased.

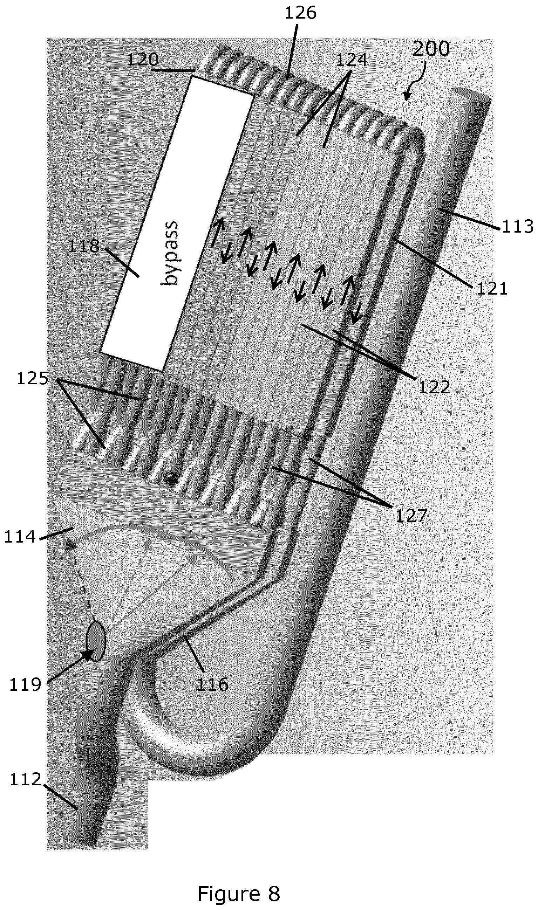

Figure 8 shows a further embodiment of a heat recovery system 200 according to the present invention. The arrangement of the inlet and outlet diffusers 114, 116, heat exchangers 120, 121 and connecting pipes 125, 126, 127 is the same as in heat recovery system 100 shown in Figure 3.

However, in Figure 8 there is no separate bypass channel. Rather, the bypass channel 118 comprises five pairs of heat exchange conduits (i.e. five adjacent conduits of the upper and lower heat exchangers 120, 121). In use, no thermoelectric generators will be in thermal contact with the heat exchange conduits forming the bypass channel 118.

In Figure 8, the bypass channel 118 is formed at the top edge of the heat exchangers 120, 121; however, in other examples the bypass channel 118 may be positioned differently. The conduits forming the bypass channel 118 do not comprise any thermally conductive fins, thus the bypass channel 118 may have a lower resistance to the fluid flow than the remaining heat exchange conduits 122, 124, which heat exchange conduits 122, 124 may comprise thermally conductive fins in some embodiments.

Optionally, the or each bypass channel may be thermally insulated from the remaining heat exchange conduits, for example by spatially separating the bypass channel(s) so that they are not in contact with the reaming heat exchange conduits. This provides improved protection of the thermoelectric modules from excessive temperature by minimising heat transfer from the bypass channel(s) to the remaining heat exchange conduits.

The conduit wall which separates the bypass channel 118 from the heat exchange conduits 122, 124 may be thermally insulated. This may prevent or reduce heat exchange between the bypass channel 118 and the thermoelectric generators (not shown) when the bypass channel 118 is activated.

A control valve 119 is located in the inlet diffuser 114. The control valve 119 is operable to regulate the flow rate through each of the heat exchange conduits 122, 124 (e.g. by adjusting the amount of fluid supplied to each first heat exchange conduit 122). This may increase the power output of the system 200 while still minimising or even cancelling the gradient in the temperature of the surfaces of the thermoelectric generators that are in thermal contact with the heat exchange conduits of the heat exchangers 120, 121.

For example, if the temperature and/or pressure of the fluid in certain heat exchange conduits 122, 124 is too high, the control valve 119 can reduce the flow rate to those conduits and redirect fluid to heat exchange conduits which have a lower temperature and/or pressure. This may prevent, in use, premature activation of the bypass channel 118 by delaying any of the thermoelectric generators from reaching a critical condition.

The control valve 119 is operable to activate the bypass channel 118 by directing the inlet fluid towards the designated conduits forming the bypass channel 118. After passing through the bypass channel 118 the fluid passes through the outlet diffuser 116 and the outlet 113, the same as when the bypass is not activated.

Thus, unlike the system in Figure 6, the bypass channel 118 in Figure 8 may not be a 'perfect' bypass, as some fluid may still flow through the heat exchange conduits 122, 124 when the bypass channel 118 is activated.

Optionally, the system in Figure 6 may comprise a control valve 119 to regulate flow rate in addition to the separate bypass channel 18 and valve 19 operable to activate the bypass channel 18.

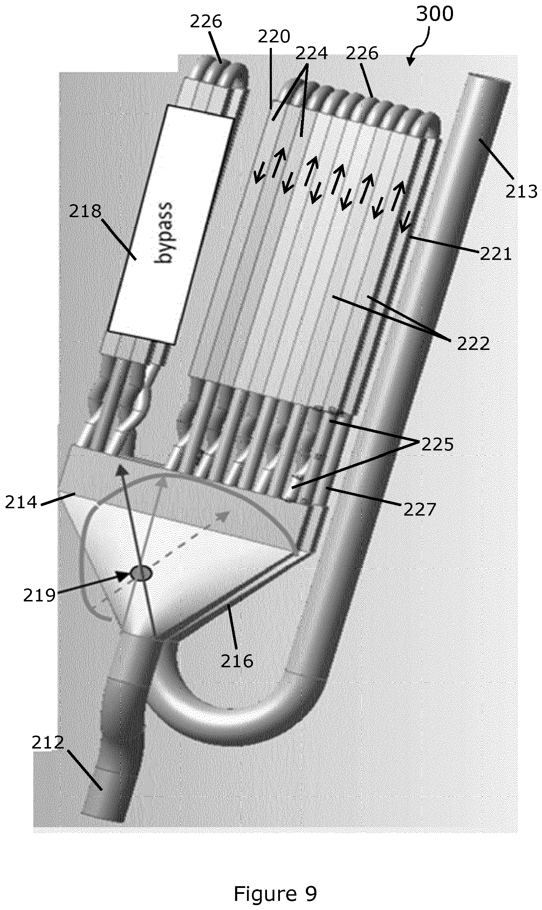

Another example of a heat recovery system 300 is shown in Figure 9. The features of system 300 are the same as system 200 shown in Figure 8, except for the bypass channel and the control valve.

In Figure 9, the control valve 219 is located further down the body of the inlet diffuser 214. The heat exchange conduits forming the bypass channel 218 are separated from (i.e. not in contact with) the remaining heat exchange conduits of the upper 220 or lower 221 heat exchangers. This air gap at least partially thermally insulates the bypass channel 218 from the thermoelectric generator(s) in contact with the heat exchange conduits 222, 224.

In Figure 9 the bypass channel 218 has been isolated by removing three of the heat exchange conduits adjacent the bypass channel 218. Thus, the bypass channel 218 is only formed of three pairs of conduits 222, 224 rather than five pairs as in Figure 8. However, in other examples the bypass channel 218 may comprise more or less than three pairs of conduits.

The positioning of the control valve 219 and the bypass channel 218 in Figure 9 provides a 'perfect' bypass, as when the control valve 219 activates the bypass channel 218 fluid cannot flow through the remaining heat exchange conduits 222, 224. The control valve 219 can also still regulate the flow rate to each of the heat exchange conduits 222, 224.

As in Figure 8, the bypass channel 218 in Figure 9 is not in thermal contact with any thermoelectric generators. Also, the heat exchange conduits forming the bypass channel 218 may not comprise any thermally conductive fins.

A possible drawback of the system 300 is that there is a reduced space to place thermoelectric generators on the heat exchangers 220, 221 (as there are fewer conduits available). This may be counteracted by providing one or more additional heat exchangers (i.e. increasing the levels of heat exchangers to three of more), or increasing the number of heat exchange conduits per heat exchanger.

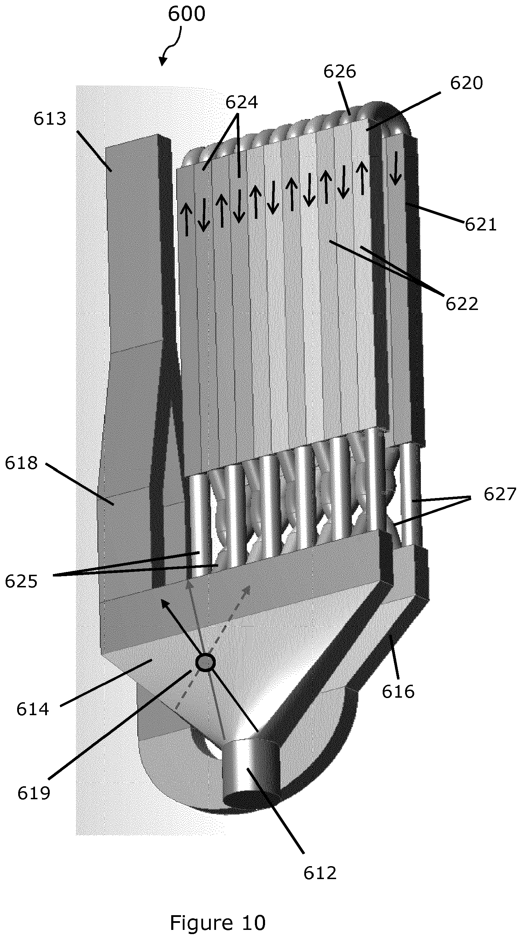

Another example of a heat recovery system 600 is shown in Figure 10. The features of system 600 are the same as system 200 shown in Figure 8, except for the bypass channel, control valve and outlet position.

In Figure 10, the control valve 619 is located further down the body of the inlet diffuser 614. The bypass channel 618 is separated from (i.e. not in contact with) the heat exchange conduits of the upper 620 or lower 621 heat exchangers.

The positioning of the control valve 619 and the bypass channel 618 in Figure 10 provides a 'perfect' bypass, as when the control valve 619 activates the bypass channel 618 fluid cannot flow through the remaining heat exchange conduits 622, 624. The control valve 619 can also still regulate the flow rate to each of the heat exchange conduits 622, 624 and connecting pipes 626, 627.

As in Figure 8, the bypass channel 618 in Figure 10 is not in thermal contact with any thermoelectric generators. The bypass channel may be a single conduit.

Figure 10 also shows that the bypass channel can connect the inlet diffuser 614 and the outlet 613, bypassing the outlet diffuser 616. This is in contrast to connecting the inlet and outlet as shown in Figure 6, or connecting the inlet and outlet diffuser as shown in Figure 8. Depending on the physical space available, any one of these configurations may be preferred.

In some embodiments, the choice of the length of the heat exchange conduits may be chosen to optimise the heat exchanger surface temperature for a certain fluid temperature and flow rate. For example the length of the heat exchange conduits can be lengthened to reduce the heat exchanger surface temperature while still providing uniformity of the heat exchanger surface temperature.

Unlike known thermoelectric heat recovery systems, it will be appreciated that the present invention may simultaneously reduce the gradient of the temperature on the hot side of the thermoelectric generator(s) and the gradient of the temperature difference across a range of operating conditions, preferably while achieving a low back pressure from the heat exchanger(s). A low back pressure can be important, for example, in exhaust systems from internal combustion engines such as in the automotive sector, where the back pressure from the heat exchanger(s) can reduce the engine performance.

Generally, in heat recovery systems according to the present invention it may be preferred to avoid utilising connecting pipes between heat exchange conduits with a short radius of curvature and/or small internal cross-sectional area. Utilising connecting pipes having a short radius of curvature could undesirably impede fluid flow, resulting in an increase in back pressure. In some embodiments, each connecting pipe between heat exchange conduits may have a radius of curvature of at least greater than the internal diameter of the connecting pipe.

Heat recovery systems according to the present invention may be particularly well suited for use in automotive applications. In particular, the heat recovery system can operate effectively at a wide range of fluid flow rates, pressures and/or temperatures, as would be experienced during normal operation of a vehicle such as a car, a bus or a lorry. For instance, typical exhaust mass flow rates are in the range 300-900 Kg/hour and typical exhaust gas temperatures are in the range 280-900 degrees C.

## Claims

1. A thermoelectric heat recovery system comprising:
an inlet for receiving a fluid;
an outlet;
N heat exchangers (10), wherein N≥2, located between, and in fluid communication with, the inlet and the outlet, each heat exchanger comprising a plurality of heat exchange conduits (2,4);
one or more first fluid paths from the inlet to the outlet, the or each first fluid path passing through, in series, a heat exchange conduit (2) in each of the N heat exchangers (10) in a first sequence;
one or more second fluid paths from the inlet to the outlet, the or each second fluid path passing through, in series, a heat exchange
conduit (4) in each of the N heat exchangers (10) in a second sequence, the second sequence being the reverse of the first sequence;
wherein, in use, the fluid flows in a first direction through a given heat exchange conduit (2) in a given heat exchanger and in a second direction opposite to the first direction through the or each heat exchange conduit (4) adjacent the given heat exchange conduit in the given heat exchanger; and
one or more thermoelectric generators, wherein the or each thermoelectric generator has a heat exchanger contact surface which is in thermal contact with at least a portion of at least two adjacent heat exchange conduits (2,4), such that, in use, the heat exchanger contact surface forms the hot side or cold side of the thermoelectric generator.

2. The system of claim 1, wherein N is up to or at least 10.

3. The system of claim 1 or claim 2, wherein each heat exchange conduit (2,4) comprises a first end (2a,4a) and a second end (2b,4b), wherein, in use, fluid flows from the first end of each heat exchange conduit to the second end of each heat exchange conduit.

4. The system of claim 3, wherein the first end of at least one heat exchange conduit in at least two of the N heat exchangers is in fluid communication with the inlet and/or wherein the second end of at least one heat exchange conduit in at least two of the N heat exchangers is in fluid communication with the outlet.

5. The system of claim 3 or claim 4, wherein each of the N heat exchangers comprises a plurality of first heat exchange conduits and a plurality of second heat exchange conduits,
the direction of fluid flow, in use, through the first heat exchange conduits being opposite that through the second heat exchange conduits, wherein each first heat exchange conduit is positioned adjacent to at least one second heat exchange conduit such that the first end of each first heat
exchange conduit is adjacent to the second end of a second heat exchange conduit.

6. The system of any of claims 1 to 5, wherein the N heat exchangers are stacked into layers.

7. The system of claim 6 as it depends on claim 5, comprising at least one upper heat exchanger (300) and at least one lower heat exchanger (301), wherein each first heat exchange conduit (303) in the upper heat exchanger(s) is in fluid communication with a second heat exchange conduit (305) in a lower heat exchanger, and each second heat exchange conduit (309 in the upper heat exchanger(s) is in fluid communication with a first heat exchange conduit (307) in a lower heat exchanger.

8. The system of any of claims 1 to 7, further comprising a plurality of connecting pipes (6,304,308) to connect the N heat exchangers in fluid communication with the inlet (302) and/or the outlet (306), preferably, wherein the plurality of connecting pipes are thermally insulated and/or are surrounded by thermal insulation.

9. The system of claim 8 , further comprising:
an inlet diffuser (14) connected to the inlet, wherein the inlet diffuser comprises a plurality of apertures, each aperture configured to receive at least one of the plurality of connecting pipes (25) and/or
an outlet diffuser (16) connected to the outlet, wherein the outlet diffuser comprises a plurality of apertures, each aperture configured to receive at least one of the plurality of connecting pipes
(27).

10. The system of claim 9 as it depends on claim 8, wherein:
the first end of each first heat exchange conduit in at least two of the N heat exchangers is connected to the inlet diffuser by one of the plurality of connecting pipes; and/or.
the second end of each second heat exchange conduit in at least two of the N heat exchangers is connected to the outlet diffuser by one of the plurality of connecting pipes.

11. The system of any of claims 1 to 10, further comprising at least one bypass channel (18) in fluid communication with the inlet,
wherein the at least one bypass channel is configured to bypass one or more of the thermoelectric generators.

12. The system of claim 11, wherein:
each of the N heat exchangers comprises at least one heat exchange conduit not in thermal contact with any of the one or more thermoelectric generators and wherein the at least one heat exchange conduit forms the bypass channel(s); and/or.
the system further comprises a valve (19) operable, in use, to activate the bypass channel(s) when the temperature and/or
pressure of the fluid exceeds a predetermined threshold, preferably wherein the valve is located within the inlet diffuser and/or wherein the valve is operable to regulate the flow rate through each of the heat exchange conduits.

13. A method of converting waste heat into electricity, the method comprising:
providing a heat recovery system according to any of claims 1 to 12;
providing a waste hot fluid or a waste cold fluid;
channelling said waste hot fluid or said waste cold fluid through the heat exchange conduits of the heat exchangers of the heat recovery system
generating electricity using the thermoelectric generator(s) of the heat recovery system.

14. An exhaust system comprising the heat recovery system of any of claims 1 to 12, wherein the fluid is an exhaust fluid and the heat exchange contact surface(s) form the hot side of the thermoelectric generator(s).

15. A structure such as a building or a vehicle comprising or having coupled thereto at least one heat recovery system according to any of claims 1 to 12.

## Patentansprüche

1. Thermoelektrisches Wärmerückgewinnungssystem, umfassend:
einen Einlass zur Aufnahme eines Fluides;
einen Auslass;
N Wärmetauscher (10), wobei N≥2, die sich zwischen und in Fluid-verbindung mit dem Einlass und dem Auslass befinden, wobei jeder Wärme-tauscher eine Vielzahl von Wärmetauschleitungen (2, 4) umfasst;
einen oder mehrere erste Fluidpfade von dem Einlass zu dem Auslass, wobei der oder jeder erste Fluidpfad der Reihe nach durch eine Wärme-tauschleitung (2) in jedem der N Wärmetauscher (10) in einer ersten Reihenfolge verläuft;
einen oder mehrere zweite Fluidpfade von dem Einlass zu dem Auslass, wobei der oder jeder zweite Fluidpfad der Reihe nach durch eine Wärme-tauschleitung (4) in jedem der N Wärmetauscher (10) in einer zweiten Reihenfolge verläuft, wobei die zweite Reihenfolge umgekehrt zu der ersten Reihenfolge ist;
wobei das Fluid im Gebrauch in einer ersten Richtung durch eine gegebene Wärmetauschleitung (2) in einem gegebenen Wärmetauscher und in einer zweiten Richtung entgegen der ersten Richtung durch die oder jede Wärmetauschleitung (4) neben der gegebenen Wärmetauschleitung in dem gegebenen Wärmetauscher strömt; und
einen oder mehrere thermoelektrische Generatoren, wobei der oder jeder thermoelektrische Generator eine Wärmetauscherkontaktfläche aufweist, die in thermischem Kontakt mit mindestens einem Abschnitt von mindestens zwei benachbarten Wärmetauschleitungen (2, 4) steht, so dass im Gebrauch die Wärmetauscherkontaktfläche die heiße Seite oder die kalte Seite des thermoelektrischen Generators bildet.

2. System nach Anspruch 1, wobei N bis zu oder mindestens 10 ist.

3. System nach Anspruch 1 oder Anspruch 2, wobei jede Wärmetauschleitung (2, 4) ein erstes Ende (2a, 4a) und ein zweites Ende (2b, 4b) umfasst, wobei im Gebrauch Fluid von dem ersten Ende der Wärmetauschleitung zu dem zweiten Ende jeder Wärmetauschleitung strömt.

4. System nach Anspruch 3, wobei sich das erste Ende von mindestens einer Wärmetauschleitung in mindestens zwei der N Wärmetauscher in Fluidverbindung mit dem Einlass befindet und/oder wobei sich das zweite Ende von mindestens einer Wärmetauschleitung in mindestens zwei der N Wärme-tauscher in Fluidverbindung mit dem Auslass befindet.

5. System nach Anspruch 3 oder Anspruch 4, wobei jeder der N Wärmetauscher eine Vielzahl von ersten Wärmetauschleitungen und eine Vielzahl von zweiten Wärmetauschleitungen umfasst, wobei die Richtung des Fluidstroms im Gebrauch durch die ersten Wärmetauschleitungen entgegengesetzt zu der durch die zweiten Wärmetauschleitungen ist, wobei jede erste Wärmetauschleitung benachbart zu mindestens einer zweiten Wärmetauschleitung positioniert ist, so dass das erste Ende jeder ersten Wärmetauschleitung benachbart zu dem zweiten Ende einer zweiten Wärmetauschleitung ist.

6. System nach einem der Ansprüche 1 bis 5, wobei die N Wärmetauscher zu Schichten gestapelt sind.

7. System nach Anspruch 6, wie es von Anspruch 5 abhängig ist, umfassend mindestens einen oberen Wärmetauscher (300) und mindestens einen unteren Wärmetauscher (301), wobei sich jede erste Wärmetauschleitung (303) in dem(den) oberen Wärmetauscher(n) in Fluidverbindung mit einer zweiten Wärmetauschleitung (305) in einem unteren Wärmetauscher befindet, und sich jede zweite Wärmetauschleitung (309) in dem(den) oberen Wärmetauscher(n) in Fluidverbindung mit einer ersten Wärmetauschleitung (307) in einem unteren Wärmetauscher befindet.

8. System nach einem der Ansprüche 1 bis 7, weiter umfassend eine Vielzahl von Verbindungsrohren (6, 304, 308) zum Verbinden der N Wärmetauscher in Fluidverbindung mit dem Einlass (302) und/oder dem Auslass (306), wobei die Vielzahl von Verbindungsrohren vorzugsweise wärmeisoliert sind und/oder von einer Wärmeisolierung umgeben sind.

9. System nach Anspruch 8, weiter umfassend:
einen Einlassdiffusor (14), der mit dem Einlass verbunden ist, wobei der Einlassdiffusor eine Vielzahl von Öffnungen umfasst, wobei jede Öffnung konfiguriert ist, um mindestens eines der Vielzahl von Verbindungsrohren (25) aufzunehmen, und/oder
einen Auslassdiffusor (16), der mit dem Auslass verbunden ist, wobei der Auslassdiffusor eine Vielzahl von Öffnungen umfasst, wobei jede Öffnung konfiguriert ist, um mindestens eines der Vielzahl von Verbindungsrohren (27) aufzunehmen.

10. System nach Anspruch 9, wie es von Anspruch 8 abhängig ist, wobei:
das erste Ende jeder ersten Wärmetauschleitung in mindestens zwei der N Wärmetauscher mit dem Einlassdiffusor durch eines der Vielzahl von Verbindungsrohren verbunden ist; und/oder
das zweite Ende jeder zweiten Wärmetauschleitung in mindestens zwei der N Wärmetauscher mit dem Auslassdiffusor durch eines der Vielzahl von Verbindungsrohren verbunden ist.

11. System nach einem der Ansprüche 1 bis 10, weiter umfassend mindestens einen Umgehungskanal (18) in Fluidverbindung mit dem Einlass, wobei der mindestens eine Umgehungskanal konfiguriert ist, um einen oder mehrere der thermoelektrischen Generatoren zu umgehen.

12. System nach Anspruch 11, wobei:
jeder der N Wärmetauscher mindestens eine Wärmetauschleitung umfasst, die nicht in thermischem Kontakt mit einem von dem einen oder den mehreren thermoelektrischen Generatoren steht, und wobei die mindestens eine Wärmetauschleitung den(die) Umgehungskanal(Umgehungskanäle) bildet; und/oder
das System weiter ein Ventil (19) umfasst, das im Gebrauch betreibbar ist, um den(die) Umgehungskanal(Umgehungskanäle) zu aktivieren, wenn die Temperatur und/oder der Druck des Fluides einen vorbestimmten Schwellenwert überschreitet, vorzugsweise wobei sich das Ventil innerhalb des Einlassdiffusors befindet und/oder wobei das Ventil betreibbar ist, um die Durchflussrate durch jede der Wärmetauschleitungen zu regeln.

13. Verfahren zum Umwandeln von Abwärme in Elektrizität, wobei das Verfahren umfasst:
Bereitstellen eines Wärmerückgewinnungssystems nach einem der Ansprüche 1 bis 12;
Bereitstellen eines heißen Abfallfluides oder eines kalten Abfallfluides;
Leiten des heißen Abfallfluides oder des kalten Abfallfluides durch die Wärmetauschleitungen der Wärmetauscher des Wärmerückgewinnungssystems
Erzeugen von Elektrizität unter Verwendung des(der) thermoelektrischen Generators(Generatoren) des Wärmerückgewinnungssystems.

14. Abgassystem, umfassend das Wärmerückgewinnungssystem nach einem der Ansprüche 1 bis 12, wobei das Fluid ein Abgasfluid ist und die Wärmetauschkontaktfläche(n) die heiße Seite des(der) thermoelektrischen Generators(Generatoren) bildet(bilden).

15. Struktur, wie etwa ein Gebäude oder ein Fahrzeug, die mindestens ein Wärmerückgewinnungssystem nach einem der Ansprüche 1 bis 12 umfasst oder damit gekoppelt ist.

## Revendications

1. Système de récupération de chaleur thermoélectrique comprenant :
une entrée pour recevoir un fluide ;
une sortie ;
N échangeurs de chaleur (10), où N≥2, situés entre, et en communication fluidique avec, l'entrée et la sortie, chaque échangeur de chaleur comprenant une pluralité de conduits d'échange de chaleur (2, 4) ;
une ou plusieurs premières trajectoires de fluide de l'entrée à la sortie, la ou chaque première trajectoire de fluide traversant, en série, un conduit d'échange de chaleur (2) dans chacun des N échangeurs de chaleur (10) dans une première séquence ;
une ou plusieurs secondes trajectoires de fluide de l'entrée à la sortie, la ou chaque seconde trajectoire de fluide traversant, en série, un conduit d'échange de chaleur (4) dans chacun des N échangeurs de chaleur (10) dans une seconde séquence, la seconde séquence étant l'inverse de la première séquence ;
dans lequel, en utilisation, le fluide s'écoule dans une première direction à travers un conduit d'échange de chaleur (2) donné dans un échangeur de chaleur donné et dans une seconde direction opposée à la première direction à travers le ou chaque conduit d'échange de chaleur (4) adjacent au conduit d'échange de chaleur donné dans l'échangeur de chaleur donné ; et
un ou plusieurs générateurs thermoélectriques, dans lequel le ou chaque générateur thermoélectrique a une surface de contact échangeuse de chaleur qui est en contact thermique avec au moins une partie d'au moins deux conduits d'échange de chaleur (2, 4) adjacents, de telle sorte que, en utilisation, la surface de contact échangeuse de chaleur forme le côté chaud ou le côté froid du générateur thermoélectrique.

2. Système selon la revendication 1, dans lequel N vaut jusqu'à ou au moins 10.

3. Système selon la revendication 1 ou la revendication 2, dans lequel chaque conduit d'échange de chaleur (2, 4) comprend une première extrémité (2a, 4a) et une seconde extrémité (2b, 4b), dans lequel, en utilisation, du fluide s'écoule de la première extrémité de chaque conduit d'échange de chaleur à la seconde extrémité de chaque conduit d'échange de chaleur.

4. Système selon la revendication 3, dans lequel la première extrémité d'au moins un conduit d'échange de chaleur dans au moins deux des N échangeurs de chaleur est en communication fluidique avec l'entrée et/ou dans lequel la seconde extrémité d'au moins un conduit d'échange de chaleur dans au moins deux des N échangeurs de chaleur est en communication fluidique avec la sortie.

5. Système selon la revendication 3 ou la revendication 4, dans lequel chacun des N échangeurs de chaleur comprend une pluralité de premiers conduits d'échange de chaleur et une pluralité de seconds conduits d'échange de chaleur, la direction de l'écoulement de fluide, en utilisation, à travers les premiers conduits d'échange de chaleur étant opposée à celle à travers les seconds conduits d'échange de chaleur, dans lequel chaque premier conduit d'échange de chaleur est positionné de manière adjacente à au moins un second conduit d'échange de chaleur de telle sorte que la première extrémité de chaque premier conduit d'échange de chaleur est adjacente à la seconde extrémité d'un second conduit d'échange de chaleur.

6. Système selon l'une quelconque des revendications 1 à 5, dans lequel les N échangeurs de chaleur sont empilés en couches.

7. Système selon la revendication 6 lorsqu'elle dépend de la revendication 5, comprenant au moins un échangeur de chaleur supérieur (300) et au moins un échangeur de chaleur inférieur (301), dans lequel chaque premier conduit d'échange de chaleur (303) dans les un ou plusieurs échangeurs de chaleur supérieurs est en communication fluidique avec un second conduit d'échange de chaleur (305) dans un échangeur de chaleur inférieur, et chaque second conduit d'échange de chaleur (309) dans les un ou plusieurs échangeurs de chaleur supérieurs est en communication fluidique avec un premier conduit d'échange de chaleur (307) dans un échangeur de chaleur inférieur.

8. Système selon l'une quelconque des revendications 1 à 7, comprenant en outre une pluralité de tuyaux de raccordement (6, 304, 308) pour raccorder les N échangeurs de chaleur en communication fluidique avec l'entrée (302) et/ou la sortie (306), de préférence dans lequel la pluralité de tuyaux de raccordement sont isolés thermiquement et/ou sont entourés par une isolation thermique.

9. Système selon la revendication 8, comprenant en outre :
un diffuseur d'entrée (14) raccordé à l'entrée, dans lequel le diffuseur d'entrée comprend une pluralité d'ouvertures, chaque ouverture étant configurée pour recevoir au moins un de la pluralité de tuyaux de raccordement (25), et/ou
un diffuseur de sortie (16) raccordé à la sortie, dans lequel le diffuseur de sortie comprend une pluralité d'ouvertures, chaque ouverture étant configurée pour recevoir au moins un de la pluralité de tuyaux de raccordement (27).

10. Système selon la revendication 9 lorsqu'elle dépend de la revendication 8, dans lequel :
la première extrémité de chaque conduit d'échange de chaleur dans au moins deux des N échangeurs de chaleur est raccordée au diffuseur d'entrée par un de la pluralité de tuyaux de raccordement ; et/ou
la seconde extrémité de chaque second conduit d'échange de chaleur dans au moins deux des N échangeurs de chaleur est raccordée au diffuseur de sortie par un de la pluralité de tuyaux de raccordement.

11. Système selon l'une quelconque des revendications 1 à 10, comprenant en outre au moins un canal de dérivation (18) en communication fluidique avec l'entrée, dans lequel l'au moins un canal de dérivation est configuré pour contourner un ou plusieurs des générateurs électriques.

12. Système selon la revendication 11, dans lequel :
chacun des N échangeurs de chaleur comprend au moins un conduit d'échange de chaleur qui n'est pas en contact thermique avec l'un quelconque des un ou plusieurs générateurs électriques et dans lequel l'au moins un conduit d'échange de chaleur forme les un ou plusieurs canaux de dérivation ; et/ou
le système comprend en outre une soupape (19) servant, en utilisation, à activer les un ou plusieurs canaux de dérivation lorsque la température et/ou la pression du fluide dépasse un seuil prédéterminé, de préférence dans lequel la soupape est située à l'intérieur du diffuseur d'entrée et/ou dans lequel la soupape sert à réguler le débit à travers chacun des conduits d'échange de chaleur.

13. Procédé de conversion de chaleur résiduaire en électricité, le procédé comprenant :
la fourniture d'un système de récupération de chaleur selon l'une quelconque des revendications 1 à 12 ;
la fourniture d'un fluide chaud résiduaire ou d'un fluide froid résiduaire ;
la canalisation dudit fluide chaud résiduaire ou dudit fluide froid résiduaire à travers les conduits d'échange de chaleur des échangeurs de chaleur du système de récupération de chaleur ;
la génération d'électricité au moyen des un ou plusieurs générateurs thermoélectriques du système de récupération de chaleur.

14. Système d'échappement comprenant le système de récupération de chaleur selon l'une quelconque des revendications 1 à 12, dans lequel le fluide est un fluide d'échappement et les une ou plusieurs surfaces de contact d'échange de chaleur forment le côté chaud des un ou plusieurs générateurs thermoélectriques.

15. Structure telle qu'un bâtiment ou un véhicule comprenant ou à laquelle est couplé au moins un système de récupération de chaleur selon l'une quelconque des revendications 1 à 12.
